# EUROPEAN PATENT SPECIFICATION

(11) **EP 3 330 762 B1**
(45) Date of publication and mention of the grant of the patent: **22.05.2019**
(21) Application number: 17180813.2
(22) Date of filing: 11.07.2017
(51) Int. Cl.: G03F 7/20, G02B 7/182

(54) **METHOD FOR ADJUSTING AN OPTICAL DEVICE**
VERFAHREN ZUR EINSTELLUNG EINER OPTISCHEN VORRICHTUNG
PROCÉDÉ DE RÉGLAGE D'UN DISPOSITIF OPTIQUE

(30) Priority: 14.07.2016 DE 102016212853
(43) Date of publication of application: 06.06.2018
(73) Proprietor: Carl Zeiss SMT GmbH, 73447 Oberkochen (DE)
(72) Inventor: Baier, Jürgen, 73447 Oberkochen (DE); Fritzsche, Steffen, 73432 Aalen (DE); Schrod, Frederik, 73430 Aalen (DE)
(74) Representative: Horn Kleimann Waitzhofer Patentanwälte PartG mbB

(56) References cited:
- US-A1- 2005 111 067
- US-A1- 2010 134 859
- US-A1- 2010 205 793
- US-A1- 2015 300 807

## Description

The present invention relates to a method for adjusting an optical device, in particular for a lithography apparatus.

Microlithography is used for producing microstructured components, such as for example integrated circuits. The microlithography process is carried out with a lithography apparatus comprising an illumination system and a projection system. The image of a mask (reticle) illuminated by means of the illumination system is in this case projected by means of the projection system onto a substrate (e.g. a silicon wafer) coated with a light-sensitive layer (photoresist) and arranged in the image plane of the projection system, in order to transfer the mask structure to the light-sensitive coating of the substrate.

Driven by the desire for ever smaller structures in the production of integrated circuits, currently under development are EUV lithography apparatuses that use light with a wavelength in the range of 0.1 nm to 30 nm, in particular 13.5 nm. In such EUV lithography apparatuses, owing to the high absorption of light having this wavelength by most materials, reflective optical units, that is to say mirrors, have to be used instead of - as previously - refractive optical units, that is to say lens elements.

The mirrors can be embodied as so-called facet mirrors, wherein such facet mirrors often have hundreds of facets in each case. Each facet is assigned a drive device, for example a Lorentz actuator, with the aid of which the respective facet is tiltable. In this case, an electromagnetic actuator actuates a magnet element provided on a drive plunger, which also carries the facet. Aligning the components of the drive device with respect to one another is complex as a result of mounting and manufacturing tolerances.

DE 10 2014 216 075 A1 describes a mirror arrangement comprising at least one individual mirror having a mirror body, a shaft, a carrying structure and an actuator, wherein the mirror body is connected to the shaft and is suspended from the carrying structure in a deflectable manner, wherein the actuator has a driven element, which is arranged on the shaft and generates an electric and/or magnetic field, and a drive system, which exerts a first force on the driven element in order to deflect the mirror body, wherein, in the deflected state of the mirror body, a restoring force directed into a non-deflected position of the shaft acts on the shaft, and wherein the individual mirror furthermore has a screening element for screening the electric and/or magnetic field and a compensation system in order to generate a second force, which is superimposed on the restoring force.

DE 10 2012 223 034 A1 discloses an illumination system of a microlithographic projection exposure apparatus comprising a facet mirror having a carrying structure and a plurality of individually adjustable mirror facets carried thereby. Via a flexure, the mirror facet is connected to the carrying structure in such a way that it is tiltable about two orthogonal axes. The mirror facet is furthermore rigidly connected to an actuating rod, such that the mirror facet is tilted about the axes by the deflection of the actuating rod by an actuator. Each flexure comprises at least three joint legs which are arranged around the actuating rod and which are secured at one end to the carrying structure and at the other end to the mirror facet or a part rigidly connected thereto, wherein the joint legs bend upon a deflection of the actuating rod.

WO 2014/060169 A1 describes a lithography apparatus comprising a multiplicity of adjustable mirrors. Each mirror is drivable by an actuator having a movable component and a housing. With the aid of the actuator, the respective mirror is tiltable relative to the housing by two degrees of freedom.

US 2015/300807 A1 discloses a method for determining the alignment of a mirror element forming part of a multi-mirror array during operation of a projection exposure apparatus. In the event of deviations of the measured alignment from a setpoint direction, the relevant mirror element may be readjusted until the desired setpoint alignment is achieved.

Against this background, it is an object of the present invention to provide an improved method for adjusting an optical device.

Accordingly, a method for adjusting an optical device, in particular for a lithography apparatus, comprising a movable component, a reference component and an optical component, is proposed, wherein the movable component is connected in a mechanical operative connection to the optical component. The method comprises the following steps: a) fixing the movable component in a mechanically defined position with respect to the reference component, b) optically measuring the optical component in order to obtain an optical measurement result, and c) adjusting the optical device depending on the optical measurement result.

What is achieved by adjusting the optical device is that an optical zero position of an optically effective surface of the optical component and of a zero position of the movable component, that is to say a mechanical zero position, can be attained simultaneously. That is to say that the movable component does not already have to be deflected in order to attain the optical zero position. As a result, nor is it necessary to apply an adjusting force to the movable component in order to attain the optical zero position. As a result, the attainable angular range by which the optical component is tiltable is maximized or a corresponding energy consumption of an actuator for driving the movable component is minimized.

The optical device can be a facet mirror. The optically effective surface can be configured to reflect EUV radiation or DUV radiation. Preferably, the movable component is embodied as a magnet element (that is to say as an element composed of a permanent-magnetic or magnetizable material). In this case, an electromagnetic actuator is preferably provided, which is configured to actuate the magnet element via an air gap (in which high vacuum prevails), that is to say to move said magnet element spatially, and to adjust the optical component by means of the mechanical operative connection. This actuation of the optical component is carried out in particular in exposure operation (for example for the exposure of a wafer with operating light) of the lithography apparatus. Any other actuator, for example a piezoactuator, can also be used instead of the electromagnetic actuator.

A "mechanical operative connection" means such a connection which transmits a movement of the movable component to the optical component. The fact that the optical device is adjusted can be understood to mean that, for example, magnetic properties of the movable component, in particular of a magnet element, are altered in order to achieve the effect that a deviation of an actual beam offset from a setpoint beam offset, said deviation being ascertained in step b), is reduced and/or that an alignment and/or positioning of the movable component relative to an electromagnetic actuator is altered. Additionally or alternatively, the optical device can also be influenced by modification of other components of the optical device, such as, for example, the optical component, in particular a facet, restoring springs, a magnetic amplification ring and/or the electromagnetic actuator itself. In order to tilt the optical component, the electromagnetic actuator, which can comprise a plurality of separately energizable coils, exerts an adjusting force on the movable component, which can be a permanent magnet. The adjusting force becomes all the greater, the further the movable component is deflected. The adjusting force is minimal, for example, if the movable component is not deflected and is positioned symmetrically with respect to the electromagnetic actuator. In this case, an axis of symmetry of the movable component can be aligned coaxially with an axis of symmetry of the electromagnetic actuator. That is to say that the movable component is situated in the mechanical zero position.

In accordance with one embodiment, a tool is provided for the fixing in step a), which tool mechanically fixes the optical component with respect to the reference component.

The tool is preferably removed again after step b). Preferably, the movable component is aligned with respect to a perforation, provided in a carrier plate, for the purpose of fixing in the mechanical zero position with the aid of the tool. The tool can be in the shape of a sleeve. An axis of symmetry of the perforation is preferably aligned with an interface provided on a carrier plate. As a result, it is not necessary to align the movable component directly with respect to the electromagnetic actuator. This simplifies and accelerates the performance of the method.

In accordance with a further embodiment, step b) comprises detecting an actual beam offset of the optical component, wherein the detected actual beam offset is compared with a setpoint beam offset and adjusting the optical device is carried out depending on the comparison result.

A detection device can be used for ascertaining the actual beam offset. The detection device can comprise for example a ground-glass screen and/or an electronic chip. In particular, a CMOS or CCD chip can be used as electronic chip. The actual beam offset can appear as a light point, particularly with the use of a ground-glass screen. The setpoint beam offset is then correspondingly a reference point, in particular on the ground-glass screen. In an optical zero position of the optically effective surface of the optical component, the deviation of the actual beam offset from the setpoint beam offset is in a predetermined tolerance range. The predetermined tolerance range can be for example 50 µm in each case for a first spatial direction and a second spatial direction. The method steps can be carried out in multiple iteration loops until the deviation of the actual beam offset from the setpoint beam offset lies in the predetermined tolerance range.

Preferably, the deviation of the actual beam offset from the setpoint beam offset is ascertained with the aid of an optical measurement method, wherein a first deviation of the actual beam offset from the setpoint beam offset in the first spatial direction and a second deviation of the actual beam offset from the setpoint beam offset in the second spatial direction are ascertained with the aid of the optical measurement method. Light in the visible wavelength range is preferably used for ascertaining the deviation of the actual beam offset from the setpoint beam offset. In particular, a suitable detection device (called: measurement machine for module qualification with visible light, MoVIS) can be employed for this purpose. For the first deviation and the second deviation it is possible to ascertain different values and to define different permissible tolerance ranges.

In accordance with a further embodiment, the adjusting in step c) comprises changing a geometry, in particular by mechanical processing, an orientation and/or position, a stiffness, an electric field and/or a magnetic field of at least one component of the optical device.

In particular, it is possible to alter a material, a shape and/or a position of a magnetic amplification ring, a strength of a magnetization, an alignment, a shape and/or a position of a magnet element, a shape, a position and/or a tilting of a facet, a position of an actuator and/or an operating point of coils of the actuator and/or a stiffness of restoring springs for adjusting the optical device.

In accordance with a further embodiment, the at least one component is the movable component, the optical component, a magnetic amplification ring, an actuator for actuating the movable component, a restoring spring for restoring the movable component and/or such a component which is comprised by the mechanical operative connection.

By way of example, a diameter of the amplification ring can be adapted. Furthermore, the amplification ring can be tilted or rotated. In particular, the position of the amplification ring can be adapted by displacing the amplification ring in the first spatial direction, the second spatial direction and/or a third spatial direction. The orientation of the amplification ring can be adapted by the amplification ring being tilted about the first spatial direction, the second spatial direction and/or the third spatial direction. By way of example, the optical component, in particular the facet, can be mechanically processed. In particular, the optically effective surface can be ground. It is also possible to set a tilting of the optical component relative to a drive plunger of the drive device. The electromagnetic actuator can be tilted or displaced, for example.

In accordance with a further embodiment, for the purpose of altering the orientation and/or the position of the movable component, a spacer element is inserted between said movable component and a drive plunger of the mechanical operative connection.

The spacer element can be a spacer washer or a so-called spacer. The spacer element can be screwed to the drive plunger, for example. The movable component is coupled to the optical component with the aid of the drive plunger, such that the optical component is tilted upon a deflection of the movable component by the adjusting force of the electromagnetic actuator. In particular, the optical component can be tilted in this case about the first spatial direction and about the second spatial direction as rotation axes. The optically effective surface faces away from the drive plunger.

Preferably, an axis of symmetry of the drive plunger is shifted and/or tilted with respect to an axis of symmetry of the drive device by the insertion of the spacer element. The axis of symmetry of the drive device can correspond to an axis of symmetry of the electromagnetic actuator. In particular, the axis of symmetry of the drive plunger is shifted and/or tilted with respect to an axis of symmetry of the movable component. The axes of symmetry can be shifted with respect to one another in the first spatial direction and/or the second spatial direction and/or can be tilted with respect to one another about the first spatial direction and/or the second spatial direction. A shift distance in the first spatial direction and/or in the second spatial direction is in this case preferably a few µm. A tilting angle about the first spatial direction and/or about the second spatial direction can be from a few fractions of a degree to a few degrees.

In accordance with a further embodiment, a geometry of the spacer element is adapted in such a way that the orientation and/or the position of the movable component are/is altered.

The spacer element can be processed by machining. Preferably, before the movable component is fixed in the mechanical zero position, a prefabricated standard blank of the spacer element is inserted between the movable component and the drive plunger in order to ascertain the deviation of the actual beam offset from the setpoint beam offset of the optically effective surface, wherein the standard blank is mechanically processed to produce the spacer element after the deviation of the actual beam offset from the setpoint beam offset has been ascertained, or the standard blank is replaced by a spacer element after the deviation of the actual beam offset from the setpoint beam offset has been ascertained.

That is to say that the standard blank can be replaced by a specially manufactured spacer element after the deviation has been ascertained. The standard blank can be a copper sheet, for example. Instead of the standard blank, it is also possible to use some other semifinished product for producing the spacer element. In this case, the standard blank can be used a number of times. The standard blank can be processed for example by machining, in particular with the aid of a CNC machine tool.

Preferably, when adjusting the optical device, a position and/or orientation of the movable component with respect to the optically effective surface is adapted depending on the deviation ascertained and/or the movable component, depending on the deviation ascertained, is magnetized asymmetrically and/or its geometry is altered. As a result, in particular it is not necessary to apply an adjusting force in order to attain the optical zero position of the optically effective surface. If the movable component is magnetized asymmetrically, it is possible that the movable component in the zero position is not necessarily aligned centrally with respect to the electromagnetic actuator. Preferably, the position and/or orientation of the movable component are/is adapted such that the actual beam offset corresponds to the setpoint beam offset or the deviation of the actual beam offset from the setpoint beam offset lies at least in the predetermined tolerance range.

In particular, the position of the movable component with respect to the optically effective surface is adapted by virtue of the fact that the movable component is displaced with respect to the optically effective surface in the first spatial direction, the second spatial direction and/or the third spatial direction, and/or wherein the orientation of the movable component with respect to the optically effective surface is adapted by virtue of the fact that the movable component is tilted with respect to the optically effective surface about the first spatial direction, the second spatial direction and/or the third spatial direction.

The position of the movable component should be understood to mean, in particular, the coordinates thereof or the coordinates of a measurement point provided on the movable component with respect to the first spatial direction or x-axis, the second spatial direction or y-axis and the third spatial direction or z-axis. The orientation of the movable component should be understood to mean, in particular, the tilting thereof with respect to the three spatial directions. That is to say that the movable component can be tilted about the first spatial direction, the second spatial direction and/or the third spatial direction. This results in six degrees of freedom for the positioning and/or orientation of the movable component with respect to the optically effective surface.

In accordance with a further embodiment, the movable component is a magnet element, wherein the magnet element is preferably movable with the aid of an electromagnetic actuator.

In accordance with a further embodiment, the reference component is a carrier plate, on which the movable component is mounted, and/or wherein the reference component is a magnetic amplification ring for an amplification of a field of an electromagnetic actuator.

Preferably, before or after the process of adapting the position and/or orientation of the movable component with respect to the optically effective surface depending on the deviation ascertained, a magnetic amplification ring is mounted in or on a perforation of the carrier plate. The amplification ring can be screwed into the perforation or clamped onto the carrier plate. The amplification ring can also be referred to as back iron ring. The amplification ring has a perforation, through which the drive plunger is led. The perforation can be arranged eccentrically on the amplification ring and/or can be oval.

In accordance with a further embodiment, the electromagnetic actuator is held by an actuator plate, wherein the actuator plate is preferably positioned relative to the carrier plate with the aid of interfaces.

In accordance with a further embodiment, the optical component is a light-reflecting component, in particular a facet.

In accordance with a further embodiment, before step c) the optical device is subjected to tactile measurement, wherein in step c) the optical device is adjusted depending on the optical measurement result and the tactile measurement result.

Preferably, a deviation of an actual position from a setpoint position of the movable component with respect to the electromagnetic actuator is ascertained with the aid of the tactile measurement method, wherein a position and/or orientation of the movable component with respect to the electromagnetic actuator are/is adapted depending on the deviation ascertained. A coordinate measuring machine can be used for the tactile measurement method. A coordinate measuring machine is based on the principle of coordinate measuring technology and includes a measuring system suitable for measuring spatial coordinates. It can comprise a measuring head system, the measurement range of which is extended by a movement or positioning system with incremental displacement or angle sensor technology. The tactile measurement method is preferably carried out in addition to the optical measurement method.

In particular, the deviation of the actual position from the setpoint position of the movable component with respect to an interface provided on a carrier plate of the drive device is ascertained with the aid of the tactile measurement method. The interface can be a fitting pin, for example. The electromagnetic actuator is preferably provided on an actuator plate of the drive device. An interface is likewise provided on the actuator plate, the electromagnetic actuator being aligned with respect to said interface. With the aid of the interfaces, the carrier plate and the actuator plate can be aligned with respect to one another in a defined manner in the three spatial directions. Since the positioning of the electromagnetic actuator relative to the interfaces is known or defined, it is not necessary to ascertain the actual position of the movable component directly with respect to the electromagnetic actuator. This simplifies the method.

In accordance with a further embodiment, the method furthermore comprises: Computing the optical measurement result and the tactile measurement result in a virtual mounting model in order to obtain a computation result, wherein in step c) the optical device is adjusted depending on the computation result.

Preferably, the ascertained deviation of the actual beam offset from the setpoint beam offset from the optically effective surface and the ascertained deviation of the actual position from the setpoint position of the movable component with respect to the electromagnetic actuator are computed regarding a mounting model of the movable component in order to adapt the position and/or orientation of the movable component with respect to the optically effective surface and simultaneously the position and/or orientation of the movable component with respect to the electromagnetic actuator. The required three-dimensional geometry of the spacer element can be determined with the aid of the virtual mounting model. The virtual mounting model can comprise a vector calculation, for example.

In particular, with the aid of the tactile measurement method, a deviation of the actual position from the setpoint position of the movable component in the third spatial direction is ascertained, which is oriented parallel to an axis of symmetry of the drive device, and/or a respective deviation of the actual position from the setpoint position of the movable component in a first spatial direction and in a second spatial direction is ascertained with the aid of the tactile measurement method. As a result, a distance between the movable component and the electromagnetic actuator that is optimum for the functionality, that is to say for the deflection of the movable component, can be ascertained and set. The spacer element is correspondingly adapted in the third spatial direction.

In accordance with a further embodiment, the tactile measurement comprises detecting a distance between two components of the optical device, in particular between the movable component and the reference component and/or at least one of the interfaces.

In accordance with a further embodiment, the optical measuring in step b) is carried out at least in a first spatial direction and in a second spatial direction, which is orthogonal to the first spatial direction, wherein the tactile measurement is carried out at least in a third spatial direction, which is orthogonal to the first and second spatial directions, wherein the tactile measurement is preferably carried out additionally in the first and second spatial directions.

Preferably, steps a) to c) are repeated until the optical measurement result lies within a defined tolerance range.

Furthermore, a method for adjusting an optical device in particular for a lithography apparatus is proposed. The method comprises the following steps: a) optically measuring the optical device in order to obtain an optical measurement result, b) subjecting the optical device to tactile measurement in order to obtain a tactile measurement result, and c) adjusting the optical device depending on the optical measurement result and the tactile measurement result.

EUV stands for "extreme ultraviolet" and denotes a wavelength of the operating light of between 0.1 nm and 30 nm. DUV stands for "deep ultraviolet" and denotes a wavelength of the operating light of between 30 nm and 250 nm.

Further possible implementations of the invention also comprise not explicitly mentioned combinations of features or embodiments that are described above or below with respect to the exemplary embodiments. In this case, the person skilled in the art will also add individual aspects as improvements or supplementations to the respective basic form of the invention.

Further advantageous configurations and aspects of the invention are the subject of the dependent claims and also of the exemplary embodiments of the invention described below. In the text that follows, the invention is explained in more detail on the basis of preferred embodiments with reference to the accompanying figures.
Figure 1A shows a schematic view of an EUV lithography apparatus;
Figure 1B shows a schematic view of a DUV lithography apparatus;
Figure 2 shows a schematic plan view of one embodiment of an optical device for the lithography apparatus in accordance with Figure 1A or 1B;
Figure 3 shows a schematic sectional view of the optical device in accordance with Figure 2;
Figure 4 shows a schematic perspective view of the optical device in accordance with Figure 2;
Figure 5 shows a further schematic sectional view of the optical device in accordance with Figure 2;
Figure 6 shows a further schematic sectional view of the optical device in accordance with Figure 2;
Figure 7 shows a schematic block diagram of one embodiment of a method for adjusting the optical device in accordance with Figure 2;
Figure 8 shows a further schematic view of the method in accordance with Figure 7; and
Figure 9 shows a highly simplified schematic view of the optical device in accordance with Figure 2.

In the figures, identical or functionally identical elements have been provided with the same reference signs, unless indicated to the contrary. In so far as a reference sign has a plurality of reference lines in the present case, this means that the corresponding element is present multiply. Reference sign lines pointing to concealed details are illustrated in a dashed manner. It should also be noted that the illustrations in the figures are not necessarily to scale.

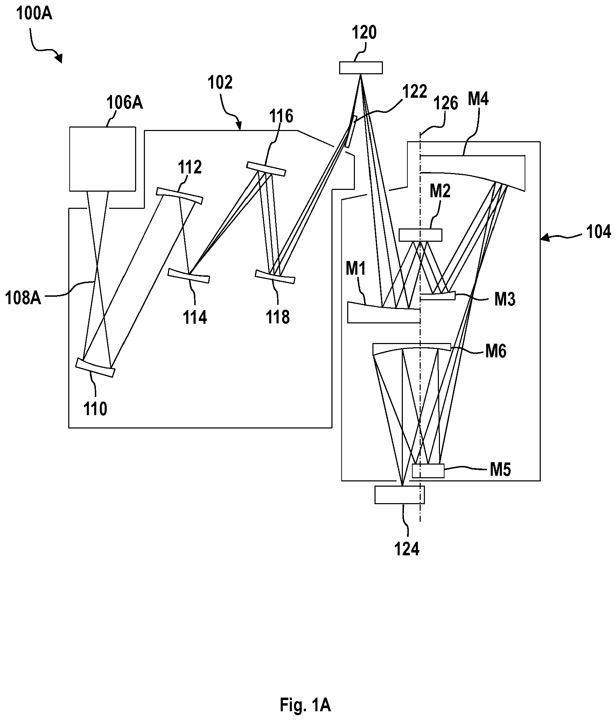

Figure 1A shows a schematic view of an EUV lithography apparatus 100A, which comprises a beam shaping and illumination system 102 and a projection system 104. In this case, EUV stands for "extreme ultraviolet" and denotes a wavelength of the operating light of between 0.1 and 30 nm. The beam shaping and illumination system 102 and the projection system 104 are provided in each case in a vacuum housing (not shown), wherein each vacuum housing is evacuated with the aid of an evacuation device (not illustrated). The vacuum housings are surrounded by a machine room (not illustrated), in which the drive devices for mechanically moving or setting the optical elements are provided. Electrical controllers and the like may also be furthermore provided in this machine room.

The EUV lithography apparatus 100A comprises an EUV light source 106A. By way of example, a plasma source (or a synchrotron) that emits radiation 108A in the EUV range (extreme ultraviolet range), that is to say e.g. in the wavelength range of 5 nm to 20 nm, can be provided as the EUV light source 106A. In the beam shaping and illumination system 102, the EUV radiation 108A is focused and the desired operating wavelength is filtered out from the EUV radiation 108A. The EUV radiation 108A generated by the EUV light source 106A has a relatively low transmissivity through air, for which reason the beam guiding spaces in the beam shaping and illumination system 102 and in the projection system 104 are evacuated.

The beam shaping and illumination system 102 illustrated in Figure 1A has five mirrors 110, 112, 114, 116, 118. After passing through the beam shaping and illumination system 102, the EUV radiation 108A is guided onto a photomask (called: reticle) 120. The photomask 120 is likewise formed as a reflective optical element and may be arranged outside the systems 102, 104. Furthermore, the EUV radiation 108A can be directed onto the photomask 120 by means of a mirror 122. The photomask 120 has a structure which is imaged onto a wafer 124 or the like in a reduced fashion by means of the projection system 104.

The projection system 104 (also referred to as projection lens) comprises six mirrors M1 to M6 for imaging the photomask 120 onto the wafer 124. In this case, individual mirrors M1 to M6 of the projection system 104 can be arranged symmetrically with respect to an optical axis 126 of the projection system 104. It should be noted that the number of mirrors of the EUV lithography system 100A is not restricted to the number illustrated. A greater or lesser number of mirrors may also be provided. Furthermore, the mirrors are generally curved at their front side for the purpose of beam shaping.

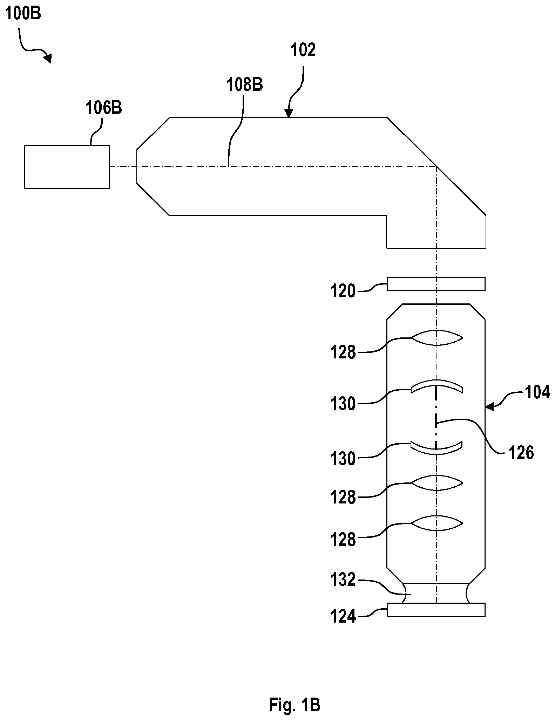

Figure 1B shows a schematic view of a DUV lithography apparatus 100B, which comprises a beam shaping and illumination system 102 and a projection system 104. In this case, DUV stands for "deep ultraviolet" and denotes a wavelength of the operating light of between 30 and 250 nm. The beam shaping and illumination system 102 and the projection system 104 can - as already described with reference to Figure 1A, be arranged in a vacuum housing, and/or be surrounded by a machine room with corresponding drive devices.

The DUV lithography apparatus 100B comprises a DUV light source 106B. By way of example, an ArF excimer laser that emits radiation 108B in the DUV range at 193 nm, for example, can be provided as the DUV light source 106B.

The beam shaping and illumination system 102 illustrated in Figure 1B guides the DUV radiation 108B onto a photomask 120. The photomask 120 is embodied as a transmissive optical element and can be arranged outside the systems 102, 104. The photomask 120 has a structure which is imaged onto a wafer 124 or the like in a reduced fashion by means of the projection system 104.

The projection system 104 has a plurality of lens elements 128 and/or mirrors 130 for imaging the photomask 120 onto the wafer 124. In this case, individual lens elements 128 and/or mirrors 130 of the projection system 104 may be arranged symmetrically in relation to the optical axis 126 of the projection system 104. It should be noted that the number of lens elements and mirrors of the DUV lithography system 100B is not restricted to the number illustrated. A greater or lesser number of lens elements and/or mirrors may also be provided. Furthermore, the mirrors are generally curved at their front side for the purpose of beam shaping.

An air gap between the last lens element 128 and the wafer 124 can be replaced by a liquid medium 132 having a refractive index of > 1. The liquid medium can be high-purity water, for example. Such a construction is also referred to as immersion lithography and has an increased photolithographic resolution.

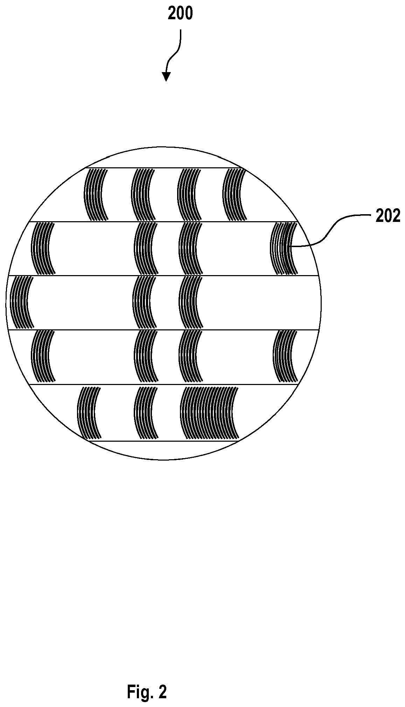

Figure 2 shows a schematic plan view of one embodiment of an optical device 200 for the lithography apparatus 100A, 100B. The optical device 200 is preferably a facet mirror. The facet mirror is designated hereinafter by the reference sign 200. The facet mirror 200 can be part of the beam shaping and illumination system 102 or of the projection system 104. By way of example, the mirrors 110, 112, 114, 116, 118 or M1 to M6 can be embodied in each case as one such facet mirror 200. The facet mirror 200 comprises a multiplicity of facets 202 arranged linearly. The facets 202 are curved arcuately or in a sickle-shaped fashion. The facets 202 can also be polygonal, for example hexagonal. Figure 2 shows only a small number of facets 202. By way of example, the facet mirror 200 can comprise several hundred to several thousand facets 202. Each facet 202 is tiltable.

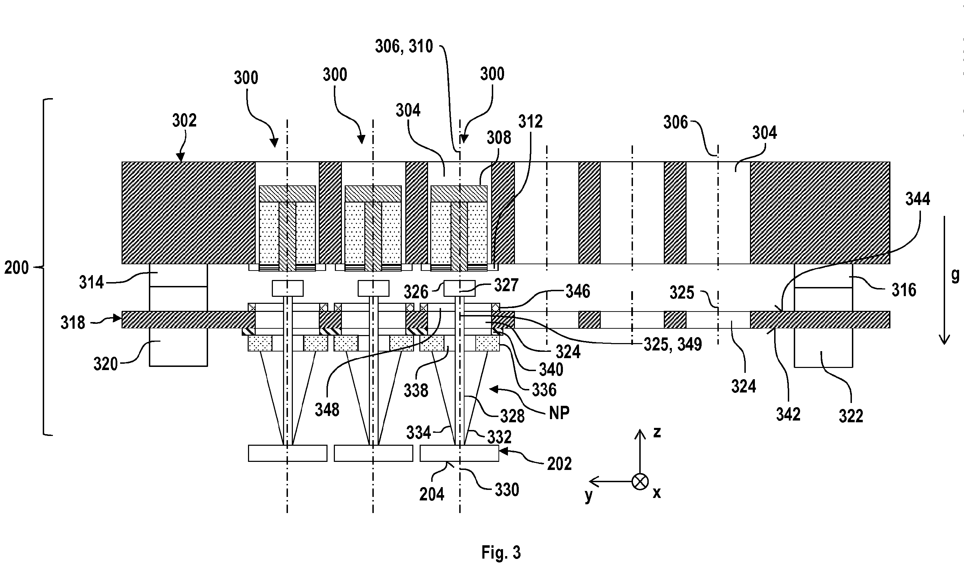

As shown in Figure 3, each facet 202 has an optically effective surface 204. The optically effective surface 204 is configured for example to reflect EUV radiation 108A or DUV radiation 108B. Furthermore, the facet mirror 200 comprises a plurality of drive devices 300.

Each facet 202 is assigned one of the drive devices 300, with the aid of which the respective facet 202 can be tilted. The drive device 300 can also be designated as a motor.

Perforations 304 are provided in an actuator plate 302 of the facet mirror 200. The perforations 304 can be embodied as circular holes penetrating through the actuator plate 302. The perforations 304 can also have a geometry deviating from a circular shape in cross section. Each perforation 304 comprises a centre axis or axis of symmetry 306, with respect to which the perforation 304 is constructed symmetrically, in particular rotationally symmetrically. The axis of symmetry 306 of the perforation 304 is simultaneously a centre axis or axis of symmetry of the drive device 300.

An electromagnetic actuator 308, in particular a Lorentz actuator, of the drive device 300 is arranged in the perforation 304. The electromagnetic actuator 308 can have a plurality of coils, for example four thereof, which are energizable separately from one another. The electromagnetic actuator 308 is embodied rotationally symmetrically with respect to a centre axis or axis of symmetry 310. The coils are arranged in a manner distributed uniformly around the axis of symmetry 310. The respective axis of symmetry 310 can be aligned coaxially with respect to the axis of symmetry 306 of the drive device 300. Coaxially should be understood to mean that the axis of symmetry 306 corresponds to the axis of symmetry 310. By way of example, the electromagnetic actuator 308 is secured in the perforation 304 with the aid of a securing ring 312.

Interfaces 314, 316 are provided on the actuator plate 302. The number of interfaces 314, 316 is arbitrary. The interfaces 314, 316 can be embodied for example as fitting pins or fitting springs. During the production of the actuator plate 302, the perforations 304 are positioned relative to the interfaces 314, 316, or vice-versa. That is to say that the position of each axis of symmetry 306 of each perforation 304 with respect to the interfaces 314, 316 in a first spatial direction x and in a second spatial direction y, different from the first spatial direction x, is known and lies within tolerances governed by production engineering.

The facet mirror 200 furthermore comprises a carrier plate 318, which is arranged below the actuator plate 302 with respect to a gravitational force direction g. Depending on the spatial arrangement of the facet mirror 200, the carrier plate 318 can also be arranged above the actuator plate 302 with respect to the gravitational force direction g.

The carrier plate 318 likewise comprises interfaces 320, 322. The interfaces 320, 322 of the carrier plate 318 correspond to the interfaces 314, 316 of the actuator plate 302. That is to say that the interfaces 320, 322 engage into the interfaces 314, 316, or vice-versa. The number of interfaces 320, 322 is arbitrary. Preferably, the number of interfaces 314, 316 of the actuator plate 302 corresponds to the number of interfaces 320, 322 of the carrier plate 318. With the aid of the interfaces 314, 316, 320, 322, the actuator plate 302 and the carrier plate 318 can be positioned relative to one another with respect to the first spatial direction x, the second spatial direction y and a third spatial direction z, which differs from the first spatial direction x and the second spatial direction y. That is to say that the interfaces 320, 322 serve on the carrier plate 318 as a reference for the positioning of components of the drive device 300 that are provided on the carrier plate 318 relative to the actuator plate 302 or relative to the electromagnetic actuator 308 or the axis of symmetry 306. The first spatial direction x can also be referred to as the x-axis, the second spatial direction y can also be referred to as the y-axis and the third spatial direction can also be referred to as the z-axis.

The carrier plate 318 has a multiplicity of perforations 324, wherein each drive device 300 is assigned a perforation 324. The perforations 324 can be embodied as circular holes. However, the perforations 324 can also have a different geometry in cross section. Each perforation 324 is assigned a centre axis or axis of symmetry 325. Ideally, in each drive device 300, the axes of symmetry 306, 310, 325 are positioned coaxially with respect to one another.

Each drive device 300 furthermore comprises a magnet element 326. The magnet element 326 is preferably embodied as a permanent magnet. The magnet element 326 comprises at least one magnetic north pole and at least one magnetic south pole. The magnet element 326 comprises a centre axis or axis of symmetry 327, with respect to which the magnet element 326 is constructed symmetrically, in particular rotationally symmetrically. The magnet element 326 is disc-shaped and can have a circular geometry. Alternatively, the magnet element 326 can also have a different geometry. The axis of symmetry 327 is ideally arranged coaxially with respect to the axes of symmetry 306, 310, 325.

The magnet element 326 is connected to a drive plunger 328. The magnet element 326 can be connected to the drive plunger 328 in a positively locking manner. A positively locking connection arises as a result of at least two connection partners engaging in or behind one another. By way of example, the magnet element 326 is screwed or clipped to the drive plunger 328. As a result, the magnet element 326 can easily be separated from the drive plunger 328 and reconnected thereto.

The facet 202 is provided at one end of the drive plunger 328. The facet 202 can be connected to the drive plunger 328 in a positively locking manner or cohesively. In the case of cohesive connections, the connection partners are held together by atomic or molecular forces. Cohesive connections are non-releasable connections that can be separated only by destruction of the connection means. By way of example, the facet 202 is adhesively bonded to the drive plunger 328.

The magnet element 326 is arranged at an end of the drive plunger 328 facing away from the facet 202. The magnet element 326 is thus coupled to the facet 202 with the aid of the drive plunger 328. The drive plunger 328 is led in the form of a rod and centrally through the perforation 324 of the carrier plate 318. The drive plunger 328 can have a centre axis or axis of symmetry 330. The axis of symmetry 330 is ideally aligned coaxially with respect to the axes of symmetry 306, 310, 325, 327. The magnet element 326 is arranged for example between the actuator plate 302 and the carrier plate 318.

In the orientation in Figure 3, the facet 202 is positioned below the carrier plate 318 with respect to the gravitational force direction g. The facet 202 is suspended from or supported on the carrier plate 318 with the aid of restoring springs 332, 334, in particular in the form of flexures. The number of restoring springs 332, 334 per facet 202 is arbitrary. By way of example, it is possible to provide two, three, four or even more restoring springs 332, 334 per facet 202. The restoring springs 332, 334 are fixedly connected to the facet 202 or to the drive plunger 328 on the facet side. A cohesive or positively locking connection can be provided.

At an end of the restoring springs 332, 334 facing away from the facet 202, said restoring springs are fixedly coupled to the carrier plate 318. A securing ring 336 can be provided for this purpose. The restoring springs 332, 334 are fixedly connected to the securing ring 336. The securing ring 336 has a central perforation 338, through which the drive plunger 328 is led. A spacer plate 340 can be provided between the securing ring 336 and the carrier plate 318. The securing ring 336 is provided on a front side 342 of the carrier plate 318. The front side 342 faces away from the actuator plate 302.

At a rear side 344 of the carrier plate 318 facing the actuator plate 302, the drive device 300 has a magnetic amplification ring 346. The amplification ring 346 serves for magnetic field amplification. The amplification ring 346 can also be designated as back iron ring (BIR). The amplification ring 346 has a central perforation 348, through which the drive plunger 328 is led. The perforation 348 can be circular or preferably oval. The amplification ring 346 is aligned centrally with respect to the perforation 324. That is to say that the amplification ring 346 is positioned such that a centre axis or axis of symmetry 349 thereof is arranged coaxially with respect to the axis of symmetry 325. By way of example, the amplification ring 346 can be screwed into the perforation 324.

The facet 202 can be tilted with the aid of the drive device 300. In particular, the facet 202 can be tilted about the first spatial direction x and about the second spatial direction y from a zero position NP shown in Figure 3 with the aid of the drive device 300 by corresponding energization of the coils of the electromagnetic actuator 308. In this case, the facet 202 is restored to the zero position NP with the aid of the restoring springs 332, 334. In the zero position NP, which can also be referred to as mechanical zero position NP as delimitation from an optical zero position of the optically effective surface 204 of the facet 202, the drive device 300 is aligned symmetrically. That is to say that the axes of symmetry 306, 310, 325, 327, 330, 349 are ideally positioned coaxially. By virtue of the restoring forces of the restoring springs 332, 334, a required adjusting force of the drive device 300 is proportional to a deflection of the drive plunger 328. The mechanical zero position NP can also be referred to as mechanical zero location, mechanical neutral location, mechanical neutral position or mechanically defined position.

During operation of the facet mirror 200, the facets 202 are tilted with the aid of the respective drive device 300. What is crucial for the functionality of the drive device 300 is the deflection, that is to say an angular range by which the drive plunger 328 can be tilted. On account of the available structural space, that is to say a length of the drive plunger 328, the dimensions of the perforation 338 in the securing ring 336, the dimensions of the perforation 324 in the carrier plate 318 and/or the dimensions of the perforation 348 in the amplification ring 346 and also electrical and magnetic properties, the adjusting force of the drive device 300 is restricted. However, the adjusting force to be expended is proportional to the attained angular range of the drive plunger 328. That is to say that the greater the deflection of the drive plunger 328, the greater the adjusting force. The greater the deflection of the drive plunger 328, the greater the current required for energizing the coils of the electromagnetic actuator 308. This can result in severe heating of the electromagnetic actuator 308.

As a result of mounting and manufacturing tolerances, the constituents of the drive device 300, namely the facet 202, the actuator plate 302, the carrier plate 318, the electromagnetic actuator 308, the magnet element 326, the drive plunger 328 and the amplification ring 346, can actually never be optimally aligned with respect to one another, or can be so aligned only with a very great technical complexity. A resulting asymmetry of the drive device 300 has the effect that even when the magnet element 326 is aligned coaxially with respect to the electromagnetic actuator 308, the optical zero position of the facet 202, in which an actual beam offset IA corresponds to a setpoint beam offset SA, is not attained. That is to say that, in order to attain the optical zero position, the drive plunger 328 must already be deflected, as a result of which the magnet element 326 is no longer centred centrally in the drive device 300. In other words, the magnet element 326 is deflected from the mechanical zero position NP in order to attain the optical zero position. This effect additionally increases the adjusting force to be applied by the drive device 300, or reduces the angular range by which the drive plunger 328 can be tilted for a given adjusting force.

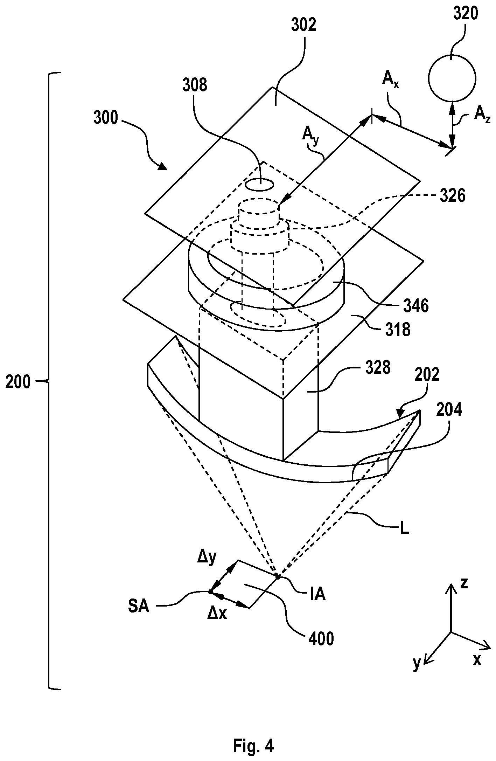

As shown in Figure 4, after the mounting of the drive device 300, the actual beam offset IA deviates from the setpoint beam offset SA of the optically defective surface 204 of the facet 202. In order to ascertain the deviation of the actual beam offset IA from the setpoint beam offset SA, a light beam L of, for example, visible light is directed onto the optically effective surface 204 of the facet 202 and is reflected therefrom in the direction of a detection device 400.

The detection device 400 can comprise for example a ground-glass screen and/or an electronic chip. In particular, a CMOS or CCD chip can be used as the electronic chip. The actual beam offset IA can appear as a light point, particularly with the use of a ground-glass screen. The setpoint beam offset SA is then correspondingly a reference point, in particular on the ground-glass screen. The actual beam offset can deviate from the setpoint beam offset SA both in the first spatial direction x and in the second spatial direction y respectively by a deviation Δx, Δy. Ideally, in the mechanical zero position NP of the magnet element 326, that is to say if the axis of symmetry 310 of the electromagnetic actuator 308 and the axis of symmetry 327 of the magnet element 326 are coaxial, the actual beam offset IA corresponds to the setpoint beam offset SA or the deviation of the actual beam offset IA from the setpoint beam offset SA lies in a predetermined tolerance range. In other words, the optically effective surface 204 of the facet 202 is then situated in its optical zero position. The predetermined tolerance range can be 50 µm, for example, both for the first spatial direction x and for the second spatial direction y.

In order to reduce the deviation of the actual beam offset IA from the setpoint beam offset SA, it is possible, as already mentioned above, for the facet 202 coupled to the drive plunger 328 to be tilted into the optical zero position with the aid of the drive device 300. In order to attain the optical zero position, the magnet element 326 is displaced out of its central mechanical zero position NP. As a result, firstly, the angular range that the drive device 300 can move to is reduced and, secondly, already in the optical zero position an adjusting force is to be applied to the magnet element 326 with the aid of the electromagnetic actuator 308.

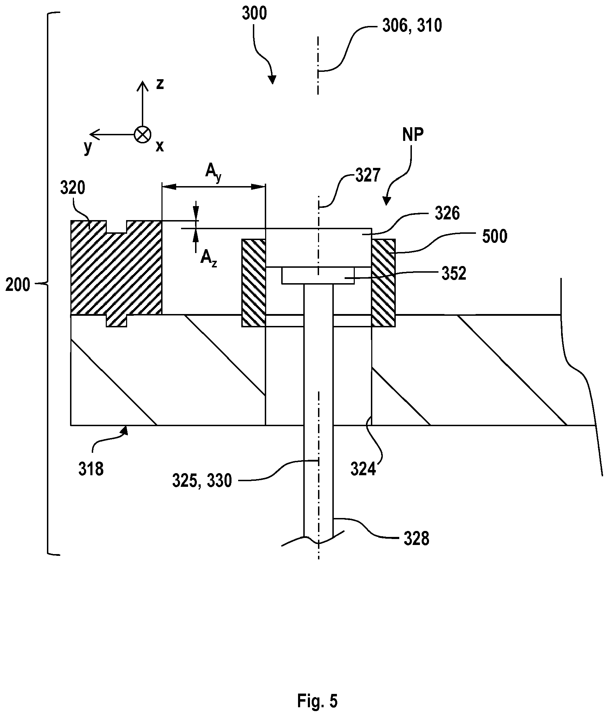

In order to avoid or at least to reduce the abovementioned effects, a method for adjusting the optical device 200 or the drive device 300 of the facet 202 is proposed. As shown in Figure 5, for this purpose, firstly the amplification ring 346 is removed and the magnet element 326 is positioned in the mechanical zero position NP with the aid of a sleeve-shaped tool 500. In this case, the magnet element is fixed with respect to the carrier plate 318, in particular with respect to one of the perforations 324, or with respect to the interface 320. With the aid of the tool 500, the magnet element 326 is fixed in all three spatial directions x, y, z. In particular, in this case, the axis of symmetry 327 of the magnet element 326 is positioned coaxially with respect to the axis of symmetry 325 of the perforation 324. Alternatively, it is also possible for the amplification ring 346 not to be demounted. In this case, the tool 500 is configured to position and fix the magnet element 326 relative to the amplification ring 346.

Since the axis of symmetry 325 of the perforation 324 is aligned with respect to the interfaces 320, 322, or the position of the axis of symmetry 325 relative to the interfaces 320, 322 with respect to the first spatial direction x and the second spatial direction y is known and the position of the electromagnetic actuator 308 with respect to the interfaces 314, 316 is defined, it suffices to fix the magnet element 326 relative to the carrier plate 318 or relative to the perforation 324 with the aid of the tool 500. That is to say that the magnet element 326 can be aligned symmetrically with respect to the axis of symmetry 325 of the perforation 324 with the aid of the tool 500.

Afterwards, with the magnet element 326 fixed in the mechanical zero position NP, the deviation of the actual beam offset IA from the setpoint beam offset SA of the optically effective surface 204 is ascertained. This ascertaining of the deviation of the actual beam offset IA from the setpoint beam offset SA is carried out with the aid of an optical measurement method. For this purpose, the detection device 400 can for example emit the light beam L onto the optically effective surface 204, wherein the light beam L is reflected from the optically effective surface 204 back to the detection device 400. In this case, the deviation of the actual beam offset IA from the setpoint beam offset SA is ascertained both in the first spatial direction x and in the second spatial direction y.

Furthermore, in the mechanical zero position NP the orientation of the magnet element 326 with respect to one of the interfaces 320, 322 is ascertained by means of a tactile measurement method, for example with the aid of a coordinate measuring machine. As a result, it is possible to ascertain in particular the position of the magnet element 326 with respect to the electromagnetic actuator 308 in the third spatial direction z. In addition, it is possible to ascertain the position of the magnet element 326 with respect to the electromagnetic actuator 308 also in the first spatial direction x and in the second spatial direction y. In this case, with the aid of the tactile measurement method, it is possible to detect for example a distance Aₓ in the first spatial direction, a distance A_{y} in the second spatial direction y and/or a distance A_{z} in the third spatial direction z (Figure 4 and Figure 5). The distances Aₓ, A_{y}, A_{z} can be ascertained for example between the magnet element 326 and one of the interfaces 320, 322.

On the basis of the measurement values ascertained with the aid of the optical measurement method and the tactile measurement method, a virtual mounting model for the magnet element 326 is subsequently ascertained. Afterwards, on the basis of said virtual mounting model, the magnet element 326 is influenced such that the deviation of the actual beam offset IA from the setpoint beam offset SA is reduced. In this case, the deviation is reduced to an extent such that predetermined tolerances, for example of a deviation of 50 µm in each case both in the first spatial direction x and in the second spatial direction y, are complied with. In particular, the magnet element 326 is influenced such that when the optically effective surface 204 of the facet 202 is situated in its optical zero position, the drive device 300 applies no or at least a minimal adjusting force.

The drive device 300 can be influenced for example by the magnet element 326 being magnetized asymmetrically. As a result, no adjusting force is to be applied in order to attain the optical zero position of the optically effective surface 204 of the facet 202. However, the magnet element 326 is then not necessarily aligned centrally with respect to the electromagnetic actuator 308 in the mechanical zero position NP.

Alternatively or additionally, a geometry, a material, a position and/or an orientation of the amplification ring 346 can be adapted in order to influence the drive device 300. Furthermore, it is also possible to adapt a geometry, a position and/or a tilting of the facet 202 and/or it is possible to adapt a position of the electromagnetic actuator 308 and/or an operating point of the coils of the electromagnetic actuator 308 depending on the deviation ascertained. Furthermore, a stiffness and/or a geometry of the restoring springs 332, 334 can be adapted.

Preferably, when influencing the drive device 300, however, a position and/or orientation of the magnet element 326 with respect to the optically effective surface 204 are/is adapted such that the actual beam offset IA corresponds to the setpoint beam offset SA or the deviation of the actual beam offset IA from the setpoint beam offset SA lies at least in the predetermined tolerance range. The predetermined tolerance range can be for example 50 µm in each case in the first spatial direction x and in the second spatial direction y. In addition, the asymmetrical magnetization can also be carried out.

The position of the magnet element 326 should be understood to mean the coordinates thereof or the coordinates of a measurement point provided on the magnet element 326 with respect to the first spatial direction x, the second spatial direction y and the third spatial direction z. The orientation of the magnet element 326 should be understood to mean the tilting thereof with respect to the three spatial directions x, y, z. That is to say that the magnet element 326 can be tilted about the first spatial direction x, the second spatial direction y and/or the third spatial direction z. This results in six degrees of freedom for the positioning and/or orientation of the magnet element 326 with respect to the optically effective surface 204.

Furthermore, the position and/or orientation of the magnet element 326 with respect to the electromagnetic actuator 308 are/is adapted such that the magnet element 326, with respect to the third spatial direction z, is arranged at a distance a from the electromagnetic actuator 308 that is required for the functionality of the drive device 300. In this case, the tolerance range to be achieved in the third spatial direction z can be 30 µm, for example.

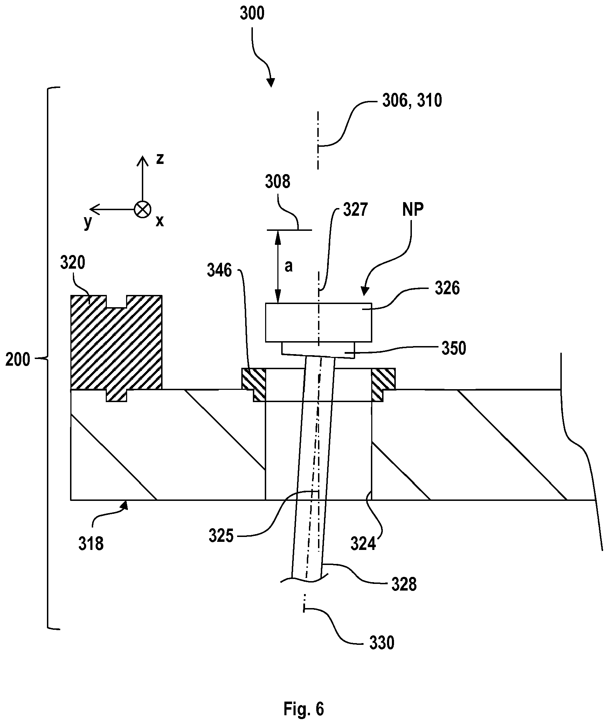

Adapting the position and/or orientation of the magnet element 326 can be carried out for example by a spacer element 350, shown in Figure 6, being inserted between the drive plunger 328 and the magnet element 326. For this purpose, before the fixing of the magnet element 326 in the zero position NP, a prefabricated standard blank 352 (Figure 5) is inserted between the magnet element 326 and the drive plunger 328. The standard blank 352 can be for example a copper sheet.

Ascertaining the deviation of the actual beam offset IA from the setpoint beam offset SA and the deviation of an actual position from a setpoint position of the magnet element 326 with respect to the electromagnetic actuator 308 is followed by ascertaining how the standard blank 352 is to be adapted, in particular assessed. For this purpose, the virtual mounting model already mentioned above is calculated.

Afterwards, the standard blank 352 is demounted from the drive device 300 and processed in a material-removing manner for example on a machine tool, in particular a CNC machine tool. In this case, material is mechanically removed from the standard blank 352 in the first spatial direction x, the second spatial direction y and/or the third spatial direction z. Alternatively, instead of the standard blank 352, it is also possible to use some other semifinished product for producing the spacer element 350. For example if the standard blank 352 has in the third spatial direction z a thickness that is too small to process said standard blank further in a material-removing manner.

After the processing of the standard blank 352 or of some other semifinished product, the spacer element 350 is completed. Afterwards, as shown in Figure 6, the spacer element 350 is incorporated into the drive device 300 again. The processing of the spacer element 350 in the first spatial direction x, the second spatial direction y and/or the third spatial direction z has the effect that when the magnet element 326 is situated in its mechanical zero position NP, that is to say that when the drive device 300 applies a minimal adjusting force, the drive plunger 328 can easily be displaced and/or tilted with respect to the magnet element 326. What is achieved as a result is that the optical zero position of the optically effective surface 204 and the mechanical zero position NP of the magnet element 326 can be attained simultaneously.

The axis of symmetry 330 of the drive plunger 228 can then be displaced with respect to the axis of symmetry 327 of the magnet element 326 or with respect to the axes of symmetry 306 or 310 in the first spatial direction x and/or in the second spatial direction y, such that the axes of symmetry 327, 330 are no longer positioned coaxially with respect to one another. Furthermore, the axis of symmetry 330 can be tilted with respect to the axis of symmetry 327 about the first spatial direction x and/or the second spatial direction y. Figure 6 shows a highly exaggerated tilting of the axis of symmetry 330 about the first spatial direction x and a highly exaggerated displacement of the axis of symmetry 330 in the second spatial direction y.

What can be achieved by the inclination of the drive plunger 328 is that, firstly, the magnet element 326 is aligned exactly centrally with respect to the axis of symmetry 310 of the electromagnetic actuator 308 and at the same time the actual beam offset IA corresponds to the setpoint beam offset SA or lies in the predetermined tolerance range. Furthermore, what can be achieved by adapting the standard blank 352 in the third spatial direction z is that the distance a between the magnet element 326 and the electromagnetic actuator 308 assumes a value that is optimal for the functionality of the drive device 300.

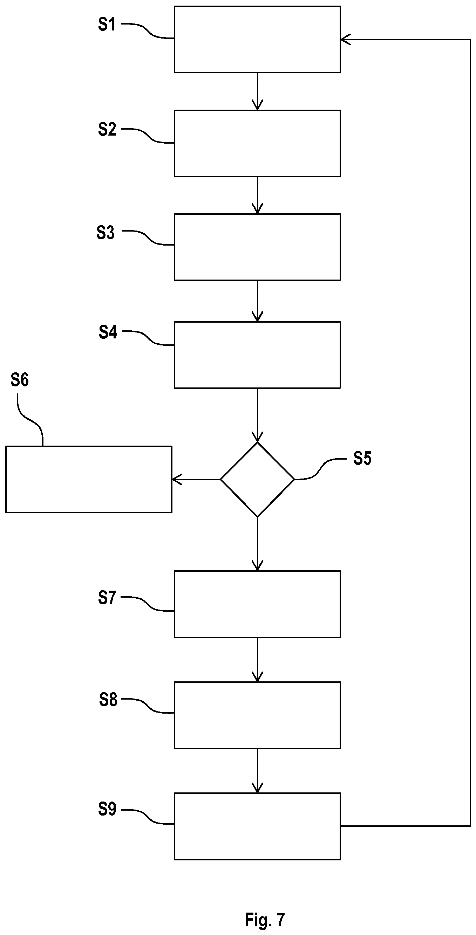

Figure 7 shows a schematic block diagram of one embodiment of the method for adjusting the optical device 200 or the drive device 300 on the basis of an influencing of the magnet element 326. In a step S1, the magnet element 326 is fixed in the mechanical zero position NP. In this case, the magnet element 326 can be fixed for example with respect to the carrier plate 318, the amplification ring 346 or the interfaces 314, 316, 320, 322. Fixing the magnet element 326 is preferably carried out with the actuator plate 302 demounted, wherein the tool 500 centres the magnet element 326 either relative to the perforation 324 or relative to the amplification ring 346.

In a step S2, the facet 202 is optically measured. In particular, the deviation of the actual beam offset IA from the setpoint beam offset SA of the optically effective surface 204 of the facet 202 is ascertained. This can be carried out with the aid of the detection device 400. In this case, the deviation of the actual beam offset IA from the setpoint beam offset SA is ascertained in the first spatial direction x and in the second spatial direction y.

In a step S3, the fixed magnet element 326 is subjected to tactile measurement. A coordinate measuring machine can be used for this purpose. For this purpose, the deviation in the first spatial direction x, the second spatial direction y and/or the third spatial direction z with respect to the electromagnetic actuator 308 is determined preferably taking account of all the interfaces 314, 316, 320, 322. In this case, in particular the deviation of the magnet element 326 in the third spatial direction z with respect to the electromagnetic actuator 308 is ascertained in order later to set the optimum distance a.

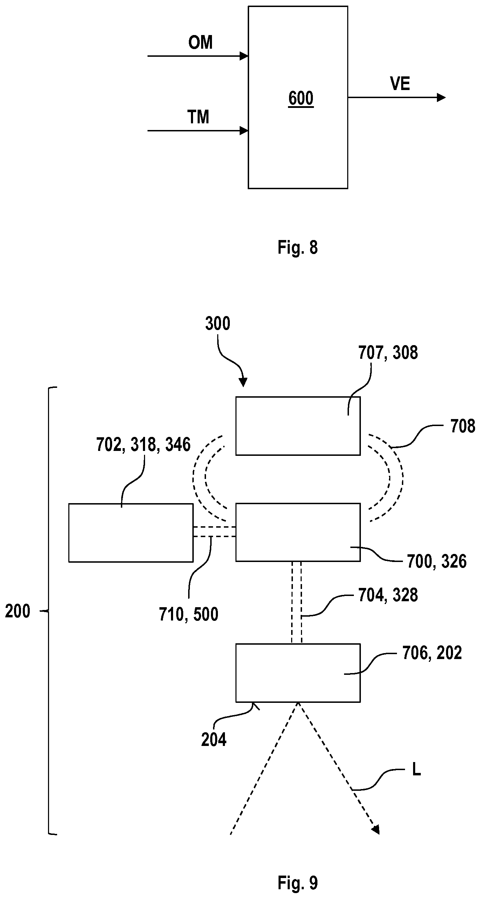

In a step S4, a virtual mounting model 600 (Figure 8) for the magnet element 326 is ascertained on the basis of the measurement values ascertained by means of the optical measurement method and the tactile measurement method.

In a step S5, a decision is taken as to whether an influencing of the magnet element 326, that is to say an adaptation of the position and/or orientation of the magnet element 326, is necessary. If no adaptation is necessary, the amplification ring 346 is mounted in a step S6. The amplification ring 346 can also already be mounted before or during step S1. Furthermore, the fixing of the magnet element 326 can be cancelled in a step S7.

If an adjustment of the drive device 300 is necessary, in a step S8 for example the magnet element 326 is influenced in such a way that the deviation of the actual beam offset IA from the setpoint beam offset SA is reduced and at the same time a minimal adjusting force is applied to the magnet element 326 with the aid of the electromagnetic actuator 308. Step S8 can be carried out before or after step S7. In particular, the magnet element 326 is adapted with regard to its position and/or orientation. For this purpose, the standard blank 352 is processed by machining for example with the aid of a CNC machine tool, such that the individually adapted spacer element 350 is made available. Alternatively, the standard blank 352 can be replaced by a specially manufactured spacer element 350. The standard blank 352 can then be used multiply.

In a step S9, the completed spacer element 350 is mounted. After step S9, steps S1 to S9 are repeated until the deviation of the actual beam offset IA from the setpoint beam offset SA is reduced to an extent such that the required tolerances are complied with.

As shown supplementarily to this in Figure 8, the optical measurement result detected in step S2, provided with the reference sign OM, and the tactile measurement result detected in step S3, provided with the reference sign TM, are computed regarding the virtual mounting model 600 for providing a computation result VE, on the basis of which step S8 of adjusting is carried out.

Figure 9 shows a greatly simplified schematic view of the facet mirror 200, which is referred to hereinafter as optical device 200. The optical device 200 comprises a movable component 700. The movable component 700 can be a facet 202. The optical device 200 furthermore comprises a reference component 702. The reference component 702 can be the carrier plate 318, one of the perforations 324 provided in the carrier plate 318, or one of the interfaces 314, 316, 320, 322.

The movable component 700 is coupled to an optical component 706 with the aid of a mechanical operative connection 704. The optical component 706 is preferably a light-reflecting component. In particular, the optical component 706 can be a facet 202. The mechanical operative connection 704 can be the drive plunger 328 or comprise the drive plunger 328. Furthermore, the optical device 200 comprises an actuator 707, which can be an electromagnetic actuator 308. The actuator 707 can be operatively connected to the movable component 700 with the aid of a field 708, in particular a magnetic field.

The method shown in Figure 7 is used for adjusting the optical device 200. In this case, the movable component 700, in step S1, is fixed in a mechanically defined position, in particular in the zero position NP, with respect to the reference component 702. In step S2, the optical component 706 is optically measured in order to obtain the optical measurement result OM. In step S8, the optical device 200 is adjusted depending on the optical measurement result OM.

For the purpose of fixing in step S1, the movable component 700 is fixed relative to the reference component 702 with the aid of a fixing system 710. The tool 500 can be provided for this purpose, which tool mechanically fixes the optical component 706 relative to the reference component 702. The tool 500 is removed again after step S3 or after step S5.

Step S2 can comprise detecting the actual beam offset IA, of the optical component 706, wherein the detected actual beam offset IA is compared with the setpoint beam offset SA and adjusting the optical device 200 is carried out depending on the comparison result.

Adjusting in step S8 can comprise changing a geometry, in particular by mechanical processing, an orientation and/or position, a stiffness, an electric field and/or the magnetic field 708 of at least one component of the optical device 200. The at least one component can be the movable component 700, the optical component 706, the magnetic amplification ring 346, the electromagnetic actuator 308 for actuating the movable component 700, the or one of the restoring springs 332, 334 for restoring the movable component 700 and/or such a component which is comprised by the mechanical operative connection 704. By way of example, the drive plunger 328 is comprised by the mechanical operative connection 704.

For altering the orientation and/or the position of the movable component 700, the spacer element 350 is inserted between said movable component and the drive plunger 328 of the mechanical operative connection. A geometry of the spacer element 350 is preferably adapted in such a way that the orientation and/or the position of the movable component 700 are/is altered. Preferably, the movable component 700 is a magnet element 326, wherein the magnet element 326 is preferably movable with the aid of the electromagnetic actuator 308.

The reference component 702 is preferably the carrier plate 318, on which the movable component 700 is mounted, and/or the reference component 702 is the magnetic amplification ring 346 for amplifying the magnetic field 708 of the electromagnetic actuator 308. Preferably, the electromagnetic actuator 308 is held by an actuator plate 302, wherein the actuator plate 302 is preferably positioned relative to the carrier plate 318 with the aid of the interfaces 314, 316, 320, 322.

Before step S8, the optical device 200 is subjected to tactile measurement, wherein, in step S8, as shown in Figure 8, the optical device 200 is adjusted depending on the optical measurement result OM and the tactile measurement result TM. The method also comprises computing the optical measurement result OM and the tactile measurement result TM in the virtual mounting model 600 in order to obtain the computation result VE, wherein the optical device 200 is adjusted depending on the computation result VE in step S8.

The tactile measurement can also comprise detecting the distance Aₓ, A_{y}, A_{z} between two components of the optical device 200, in particular between the movable component 700 and the reference component 702 and/or between the movable component 700 and at least one of the interfaces 314, 316, 320, 322.

The optical measurement in step S2 is carried out in the first spatial direction x and in the second spatial direction y, which is orthogonal to the first spatial direction x, wherein the tactile measurement is carried out at least in the third spatial direction z, which is orthogonal to the first and second spatial directions x, y, wherein the tactile measurement is preferably carried out additionally in the first and second spatial directions x, y.

The method can comprise the steps of optically measuring S2 the optical device 200 in order to obtain an optical measurement result OM, subjecting the optical device 200 to tactile measurement S3 in order to obtain a tactile measurement result TM, and adjusting S8 the optical device 200 depending on the optical measurement result OM and the tactile measurement result TM.

Although the invention has been described here on the basis of preferred exemplary embodiments, it is in no way restricted thereto, but rather can be modified in diverse ways. The invention is defined by the claims.

### LIST OF REFERENCE SIGNS

- 100A: EUV lithography apparatus
- 100B: DUV lithography apparatus
- 102: Beam shaping and illumination system
- 104: Projection system
- 106A: EUV light source
- 106B: DUV light source
- 108A: EUV radiation
- 108B: DUV radiation
- 110: Mirror
- 112: Mirror
- 114: Mirror
- 116: Mirror
- 118: Mirror
- 120: Photomask
- 122: Mirror
- 124: Wafer
- 126: Optical axis
- 128: Lens element
- 130: Mirror
- 132: Immersion liquid
- 200: Optical device/facet mirror
- 202: Facet
- 204: Surface
- 300: Drive device
- 302: Actuator plate
- 304: Perforation
- 306: Axis of symmetry
- 308: Actuator
- 310: Axis of symmetry
- 312: Securing ring
- 314: Interface
- 316: Interface
- 318: Carrier plate
- 320: Interface
- 322: Interface
- 324: Perforation
- 325: Axis of symmetry
- 326: Magnet element
- 327: Axis of symmetry
- 328: Drive plunger
- 330: Axis of symmetry
- 332: Restoring spring
- 334: Restoring spring
- 336: Securing ring
- 338: Perforation
- 340: Spacer plate
- 342: Front side
- 344: Rear side
- 346: Amplification ring
- 348: Perforation
- 349: Axis of symmetry
- 350: Spacer element
- 352: Standard blank
- 400: Detection device
- 500: Tool
- 600: Virtual mounting model
- 700: Movable component
- 702: Reference component
- 704: Mechanical operative connection
- 706: Optical component
- 707: Actuator
- 708: Field
- 710: Fixing system

- a: Distance
- Aₓ: Distance
- A_{y}: Distance
- A_{z}: Distance
- g: Gravitational force direction
- IA: Actual beam offset
- L: Light beam
- M1: Mirror
- M2: Mirror
- M3: Mirror
- M4: Mirror
- M5: Mirror
- M6: Mirror
- NP: Zero position
- OM: Optical measurement result
- SA: Setpoint beam offset
- S1: Step
- S2: Step
- S3: Step
- S4: Step
- S5: Step
- S6: Step
- S7: Step
- S8: Step
- S9: Step
- TM: Tactile measurement result
- VE: Computation result
- x: Spatial direction
- y: Spatial direction
- z: Spatial direction
- Δx: Deviation
- Δy: Deviation

## Claims

1. Method for adjusting an optical device (200), in particular for a lithography apparatus (100A, 100B), comprising a movable component (326, 700), a reference component (318, 346, 702) and an optical component (202, 706), wherein the movable component (326, 700) is connected by a mechanical operative connection (328, 704) to the optical component (202, 706), comprising the following steps:
a) fixing (S1) the movable component (326, 700) in a mechanically defined position (NP) with respect to the reference component (318, 346, 702),
b) optically measuring (S2) the optical component (202, 706) in order to obtain an optical measurement result (OM), and
c) adjusting (S8) the optical device (200) depending on the optical measurement result (OM).

2. Method according to Claim 1, wherein a tool (500, 701) is provided for the fixing in step a), which tool mechanically fixes the optical component (202, 706) with respect to the reference component (318, 346, 702).

3. Method according to Claim 1 or 2, wherein step b) comprises detecting an actual beam offset (IA) of the optical component (202, 706), wherein the detected actual beam offset (IA) is compared with a setpoint beam offset (SA) and adjusting the optical device (200) is carried out depending on the comparison result.

4. Method according to any of the preceding claims, wherein the adjusting in step c) comprises changing a geometry, in particular by mechanical processing, an orientation and/or position, a stiffness, an electric field and/or a magnetic field (708) of at least one component (202, 308, 326, 328, 346, 700, 704, 706, 707) of the optical device (200).

5. Method according to Claim 4, wherein the at least one component is the movable component (326, 700), the optical component (202, 706), a magnetic amplification ring (346), an actuator (308, 707) for actuating the movable component (326, 700), a restoring spring (332, 334) for restoring the movable component (326, 700) and/or such a component which is comprised by the mechanical operative connection (328, 704).

6. Method according to Claim 4 or 5, wherein, for the purpose of altering the orientation and/or the position of the movable component (326, 700), a spacer element (350) is inserted between said movable component and a drive plunger (328) of the mechanical operative connection (704).

7. Method according to Claim 6, wherein a geometry of the spacer element (350) is adapted in such a way that the orientation and/or the position of the movable component (326, 700) are/is altered.

8. Method according to any of the preceding claims, wherein the movable component (700) is a magnet element (326), wherein the magnet element (326) is preferably movable with the aid of an electromagnetic actuator (308).

9. Method according to any of the preceding claims, wherein the reference component (702) is a carrier plate (318), on which the movable component (326, 700) is mounted, and/or wherein the reference component (702) is a magnetic amplification ring (346) for an amplification of a field (708) of an electromagnetic actuator (308).

10. Method according to Claim 8 or 9, wherein the electromagnetic actuator (308) is held by an actuator plate (302), wherein the actuator plate (302) is preferably positioned relative to the carrier plate (318) with the aid of interfaces (314, 316, 320, 322).

11. Method according to any of the preceding claims, wherein the optical component (706) is a light-reflecting component, in particular a facet (202).

12. Method according to any of the preceding claims, wherein before step c) the optical device (200) is subjected to tactile measurement (S3) and wherein in step c) the optical device (200) is adjusted (S8) depending on the optical measurement result (OM) and the tactile measurement result (TM).

13. Method according to Claim 12, furthermore comprising:
Computing (S4) the optical measurement result (OM) and the tactile measurement result (TM) in a virtual mounting model (600) in order to obtain a computation result (VE), wherein in step c) the optical device (200) is adjusted depending on the computation result (VE).

14. Method according to Claim 12 or 13, wherein the tactile measurement comprises detecting a distance (Aₓ, A_{y}, A_{z}) between two components (314, 316, 318, 320, 322, 326, 346, 700, 702) of the optical device (200), in particular between the movable component (326, 700) and the reference component (318, 346, 702) and/or at least one of the interfaces (314, 316, 320, 322).

15. Method according to any of Claims 12 to 14, wherein the optical measurement in step b) is carried out at least in a first spatial direction and in a second spatial direction (y), which is orthogonal to the first spatial direction (x), and wherein the tactile measurement is carried out at least in a third spatial direction (z), which is orthogonal to the first and second spatial directions (x, y), wherein the tactile measurement is preferably carried out additionally in the first and second spatial directions (x, y).

## Patentansprüche

1. Verfahren zum Justieren einer optischen Vorrichtung (200), insbesondere für eine Lithographieanlage (100A, 100B), das eine bewegliche Komponente (326, 700), eine Referenzkomponente (318, 346, 702) und eine optische Komponente (202, 706) umfasst, wobei die bewegliche Komponente (326, 700) durch eine mechanische Wirkverbindung (328, 704) mit der optischen Komponente (202, 706) verbunden ist, welches die folgenden Schritte umfasst:
a) Fixieren (S1) der beweglichen Komponente (326, 700) in einer mechanisch definierten Position (NP) mit Bezug auf die Referenzkomponente (318, 346, 702),
b) optisches Messen (S2) der optischen Komponente (202, 706), um ein optisches Messergebnis (OM) zu erhalten, und
c) Justieren (S8) der optischen Vorrichtung (200) in Abhängigkeit von dem optischen Messergebnis (OM).

2. Verfahren nach Anspruch 1, wobei ein Werkzeug (500, 701) für das Fixieren in Schritt a) bereitgestellt wird, wobei das Werkzeug die optische Komponente (202, 706) mechanisch mit Bezug auf die Referenzkomponente (318, 346, 702) fixiert.

3. Verfahren nach Anspruch 1 oder 2, wobei Schritt b) Detektieren eines Ist-Strahlversatzes (IA) der optischen Komponente (202, 706) umfasst, wobei der detektierte Ist-Strahlversatz (IA) mit einem Soll-Strahlversatz (SA) verglichen wird und das Justieren der optischen Vorrichtung (200) in Abhängigkeit von dem Vergleichsergebnis ausgeführt wird.

4. Verfahren nach einem der vorhergehenden Ansprüche, wobei das Justieren in Schritt c) Ändern einer Geometrie, insbesondere durch mechanisches Verarbeiten, einer Orientierung und/oder Position, einer Steifigkeit, eines elektrischen Feldes und/oder eines magnetischen Feldes (708) wenigstens einer Komponente (202, 308, 326, 328, 346, 700, 704, 706, 707) der optischen Vorrichtung (200) umfasst.

5. Verfahren nach Anspruch 4, wobei die wenigstens eine Komponente die bewegliche Komponente (326, 700), die optische Komponente (202, 706), ein magnetischer Verstärkungsring (346), ein Aktor (308, 707) zum Antreiben der beweglichen Komponente (326, 700), eine Rückstellfeder (332, 334) zum Rückstellen der beweglichen Komponente (326, 700) und/oder eine solche Komponente ist, die durch die mechanische Wirkverbindung (328, 704) enthalten ist.

6. Verfahren nach Anspruch 4 oder 5, wobei zum Zweck einer Veränderung der Orientierung und/oder der Position der beweglichen Komponente (326, 700) ein Abstandhalterelement (350) zwischen der beweglichen Komponente und einem Antriebsstößel (328) der mechanischen Wirkverbindung (704) eingefügt wird.

7. Verfahren nach Anspruch 6, wobei eine Geometrie des Abstandhalterelements (350) derart eingerichtet wird, dass die Orientierung und/oder die Position der beweglichen Komponente (326, 700) verändert wird/werden.

8. Verfahren nach einem der vorhergehenden Ansprüche, wobei die bewegliche Komponente (700) ein Magnetelement (326) ist, wobei das Magnetelement (326) bevorzugt mit der Hilfe eines elektromagnetischen Aktors (308) bewegbar ist.

9. Verfahren nach einem der vorhergehenden Ansprüche, wobei die Referenzkomponente (702) eine Trägerplatte (318) ist, auf der die bewegliche Komponente (326, 700) montiert ist, und/oder wobei die Referenzkomponente (702) ein magnetischer Verstärkungsring (346) für eine Verstärkung eines Feldes (708) eines elektromagnetischen Aktors (308) ist.

10. Verfahren nach Anspruch 8 oder 9, wobei der elektromagnetische Aktor (308) durch eine Aktorplatte (302) gehalten wird, wobei bevorzugt die Aktorplatte (302) mit der Hilfe von Schnittstellen (314, 316, 320, 322) relativ zu der Trägerplatte (318) positioniert wird.

11. Verfahren nach einem der vorhergehenden Ansprüche, wobei die optische Komponente (706) eine lichtreflektierende Komponente, insbesondere eine Facette (202), ist.

12. Verfahren nach einem der vorhergehenden Ansprüche, wobei vor Schritt c) die optische Vorrichtung (200) einer taktilen Messung (S3) unterzogen wird und wobei in Schritt c) die optische Vorrichtung (200) in Abhängigkeit von dem optischen Messergebnis (OM) und dem taktilen Messergebnis (TM) justiert (S8) wird.

13. Verfahren nach Anspruch 12, das ferner Folgendes umfasst:
Verrechnen (S4) des optischen Messergebnisses (OM) und des taktilen Messergebnisses (TM) in einem virtuellen Montagemodell (600), um ein Verrechnungsergebnis (VE) zu erhalten, wobei in Schritt c) die optische Vorrichtung (200) in Abhängigkeit von dem Verrechnungsergebnis (VE) justiert wird.

14. Verfahren nach Anspruch 12 oder 13, wobei die taktile Messung Detektieren eines Abstands (Aₓ, A_{y}, A_{z}) zwischen zwei Komponenten (314, 316, 318, 320, 322, 326, 346, 700, 702) der optischen Vorrichtung (200), insbesondere zwischen der beweglichen Komponente (326, 700) und der Referenzkomponente (318, 346, 702) und/oder wenigstens einer der Schnittstellen (314, 316, 320, 322), umfasst.

15. Verfahren nach einem der Ansprüche 12 bis 14, wobei die optische Messung in Schritt b) wenigstens in einer ersten räumlichen Richtung und in einer zweiten räumlichen Richtung (y), die zu der ersten räumlichen Richtung (x) orthogonal ist, ausgeführt wird und wobei die taktile Messung wenigstens in einer dritten räumlichen Richtung (z), die zu der ersten und zweiten räumlichen Richtung (x, y) orthogonal ist, ausgeführt wird, wobei die taktile Messung bevorzugt zusätzlich in der ersten und zweiten räumlichen Richtung (x, y) ausgeführt wird.

## Revendications

1. Procédé d'ajustement d'un dispositif optique (200), en particulier pour un appareil lithographique (100A, 100B), comprenant un composant mobile (326, 700), un composant de référence (318, 346, 702) et un composant optique (202, 706), dans lequel le composant mobile (326, 700) est relié par une liaison opérante mécanique (328, 704) au composant optique (202, 706), comprenant les étapes suivantes consistant à :
a) fixer (S1) le composant mobile (326, 700) dans une position définie mécaniquement (NP) par rapport au composant de référence (318, 346, 702),
b) mesurer optiquement (S2) le composant optique (202, 706) dans le but d'obtenir un résultat de mesure optique (OM), et
c) ajuster (S8) le dispositif optique (200) en fonction du résultat de mesure optique (OM).

2. Procédé selon la revendication 1, dans lequel un outil (500, 701) est prévu pour la fixation à l'étape a), lequel outil fixe mécaniquement le composant optique (202, 706) par rapport au composant de référence (318, 346, 702).

3. Procédé selon la revendication 1 ou 2, dans lequel l'étape b) consiste à détecter un décalage de faisceau réel (IA) du composant optique (202, 706), dans lequel le décalage de faisceau réel (IA) détecté est comparé à un décalage de faisceau de point de consigne (SA) et l'ajustement du dispositif optique (200) est réalisé en fonction du résultat de la comparaison.

4. Procédé selon l'une quelconque des revendications précédentes, dans lequel l'ajustement à l'étape c) consiste à changer une géométrie, en particulier par un traitement mécanique, une orientation et/ou une position, une rigidité, un champ électrique et/ou un champ magnétique (708) d'au moins un composant (202, 308, 326, 328, 346, 700, 704, 706, 707) du dispositif optique (200).

5. Procédé selon la revendication 4, dans lequel l'au moins un composant est le composant mobile (326, 700), le composant optique (202, 706), un anneau d'amplification magnétique (346), un actionneur (308, 707) pour actionner le composant mobile (326, 700), un ressort de rappel (332, 334) pour rappeler le composant mobile (326, 700) et/ou un tel composant qui est compris par la liaison opérante mécanique (328, 704).

6. Procédé selon la revendication 4 ou 5, dans lequel, dans le but de modifier l'orientation et/ou la position du composant mobile (326, 700), un élément d'espacement (350) est introduit entre ledit composant mobile et un piston d'entraînement (328) de la liaison opérante mécanique (704).

7. Procédé selon la revendication 6, dans lequel une géométrie de l'élément d'espacement (350) est conçue de sorte que l'orientation et/ou la position du composant mobile (326, 700) soient/soit modifiée(s).

8. Procédé selon l'une quelconque des revendications précédentes, dans lequel le composant mobile (700) est un élément magnétique (326), dans lequel l'élément magnétique (326) est de préférence mobile à l'aide d'un actionneur électromagnétique (308).

9. Procédé selon l'une quelconque des revendications précédentes, dans lequel le composant référence (702) est une plaque de support (318), sur laquelle est monté le composant mobile (326, 700), et/ou dans lequel le composant de référence (702) est un anneau d'amplification magnétique (346) pour une amplification d'un champ (708) d'un actionneur électromagnétique (308).

10. Procédé selon la revendication 8 ou 9, dans lequel l'actionneur électromagnétique (308) est maintenu par une plaque (302) d'actionneur, dans lequel la plaque (302) d'actionneur est de préférence positionnée par rapport à la plaque de support (318) à l'aide d'interfaces (314, 316, 320, 322).

11. Procédé selon l'une quelconque des revendications précédentes, dans lequel le composant optique (706) est un composant de réflexion de lumière, en particulier une facette (202).

12. Procédé selon l'une quelconque des revendications précédentes, dans lequel, avant l'étape c), le dispositif optique (200) est soumis à une mesure tactile (S3) et dans lequel, à l'étape c), le dispositif optique (200) est ajusté (S8) en fonction du résultat de mesure optique (OM) et du résultat de mesure tactile (TM).

13. Procédé selon la revendication 12, consistant en outre à :
calculer (S4) le résultat de mesure optique (OM) et le résultat de mesure tactile (TM) dans un modèle de montage virtuel (600) dans le but d'obtenir un résultat de calcul (VE), dans lequel à l'étape c) le dispositif optique (200) est ajusté en fonction du résultat de calcul (VE).

14. Procédé selon la revendication 12 ou 13, dans lequel la mesure tactile consiste à détecter une distance (Aₓ, A_{y} A_{z}) entre deux composants (314, 316, 318, 320, 322, 326, 346, 700, 702) du dispositif optique (200), en particulier entre le composant mobile (326, 700) et le composant de référence (318, 346, 702) et/ou au moins une des interfaces (314, 316, 320, 322) .

15. Procédé selon l'une quelconque des revendications 12 à 14, dans lequel la mesure optique à l'étape b) est réalisée au moins dans une première direction spatiale et dans une deuxième direction spatiale (y), qui est perpendiculaire à la première direction spatiale (x), et dans lequel la mesure tactile est réalisée dans au moins une troisième direction spatiale (z), qui est perpendiculaire aux première et deuxième directions spatiales (x y), dans lequel la mesure tactile est de préférence réalisée par ailleurs dans les première et deuxième directions spatiales (x, y).
